# EUROPÄISCHE PATENTSCHRIFT

(11) **EP 3 175 251 B1**
(45) Veröffentlichungstag und Bekanntmachung des Hinweises auf die Patenterteilung: **07.06.2023**
(21) Anmeldenummer: 15763874.3
(22) Anmeldetag: 10.09.2015
(51) Int. Cl.: G01R 31/327, G01R 15/04, G01R 19/32

(54) **SCHALTUNGSANORDNUNG MIT EINEM MINDESTENS EINEN BINÄREN EINGANG AUFWEISENDEN STEUERGERÄT UND ZUGEHÖRIGES BETRIEBSVERFAHREN**
CIRCUIT ARRANGEMENT COMPRISING A CONTROL DEVICE HAVING AT LEAST ONE BINARY INPUT, AND ASSOCIATED OPERATING METHOD
CIRCUIT COMPRENANT UN APPAREIL DE COMMANDE PRÉSENTANT AU MOINS UNE ENTRÉE BINAIRE ET PROCÉDÉ DE FONCTIONNEMENT ASSOCIÉ

(30) Priorität: 25.09.2014 DE 102014219468
(43) Veröffentlichungstag der Anmeldung: 07.06.2017
(73) Patentinhaber: Siemens Aktiengesellschaft, 80333 München (DE)
(72) Erfinder: FLAUAUS, Christian, 64521 Gross-Gerau (DE); KLÜPPEL, Heinz Eugen, 53859 Niederkassel (DE)
(74) Vertreter: Siemens Patent Attorneys
(86) Internationale Anmeldenummer: PCT/EP2015/070711
(87) Internationale Veröffentlichungsnummer: WO 2016/045981

(56) Entgegenhaltungen:
- WO-A2-03/039904
- DE-A1-102011 108 229
- DE-B3-102005 004 608
- US-A1- 2008 197 699
- US-A1- 2009 289 572
- ZA-A- 9 602 539

## Beschreibung

Die Erfindung betrifft eine Schaltungsanordnung mit einem mindestens einen binären Eingang aufweisenden Steuergerät. Sie betrifft weiterhin ein zugehöriges Betriebsverfahren.

Zur Steuerung von Motoren werden in vielen Fällen Steuerungseinrichtungen bzw. Steuergeräte mit binären Eingängen verwendet. Ein Beispiel hierfür ist die so genannte Motor Control Unit (MCU). Über deren binäre Eingänge werden Freigaben und Rückmeldungen von einem zugeordneten Schaltgerät bzw. Schalter abgefragt sowie die Befehle zum Verfahren der Motoren gegeben. Üblicherweise sind die Eingänge vom Typ "HIGH aktiv", und bei anliegendem Potenzial schaltet der Eingang ab einer bestimmten Schaltschwelle (üblich beispielsweise 0,5 × Steuerspannung) von logisch 0 (LOW) auf 1 (HIGH). Die Freigaben, Rückmeldungen und Befehle sind über diverse Schaltelemente wie beispielsweise Hilfsschalter, Meldeschalter und Positionsschalter, sowie über Klemmstellen geführt.

Da es sich um binäre Eingänge mit üblicherweise großer Eingangsimpedanz handelt (typischerweise > 30 kOhm), ist ein Potenzial am Eingang bei sehr geringem Strom ausreichend, um die Steuerung zu aktivieren. Wird die Steuerung unter klimatisch anspruchsvollen Umgebungsbedingungen eingesetzt (z. B. Offshore, Küstennähe, hohe Luftverschmutzung, extreme Luftfeuchtigkeit), können sich Kriechwege ausbilden, welche einen sinkenden Isolationswiderstand zur Folge haben. Hierdurch kann es zu Potenzialverschleppungen auf den Schaltelementen sowie den Klemmstellen kommen und damit zu ungewollten Freigaben und Steuerbefehlen.

Da die Kriechwege in vielen Fällen eine sehr begrenzte Stromtragfähigkeit aufweisen, ist es Stand der Technik, die Eingangswiderstände der Steuerungseinrichtungen zu reduzieren. Dies wird üblicherweise durch Pulldown-Widerstände realisiert.

Eine Schaltanordnung zur Überprüfung von elektrischen Kontaktierungen ist in der DE102005004608B3 offenbart, wobei die Verwendung eines Pulldown-Widerstandes und eines Pullup-Widerstandes zur Überprüfung beschrieben werden.

Die ZA9602539A offenbart eine Temperaturüberwachung für einen Generator, insbesondere eine Lichtmaschine für ein Fahrzeug, wobei zur Temperaturüberwachung ein Spannungsteiler mit einem temperaturvariablen Widerstand und einem temperaturkonstanten Widerstand verwendet werden.

Die DE102011108229A1 beschreibt ein Verfahren und eine Vorrichtung zur Überprüfung von KFZ-Steckdosen, wobei Pullup-Widerstände und Pulldown-Widerstände verwendet werden.

Eine Temperaturüberwachung für ein Vorschaltgerät wird in der US20090289572A1 offenbart, wobei ein Spannungsteiler mit einem temperaturvariablen Widerstand und einem temperaturkonstanten Widerstand beschrieben wird.

Der Erfindung liegt die Aufgabe zugrunde, eine Schaltungsanordnung bzw. ein Betriebsverfahren der eingangs genannten Art anzugeben, welche die negativen Auswirkungen von Kriechwegen reduzieren.

In Bezug auf die Schaltungsanordnung wird die Aufgabe dadurch gelöst, dass bei der Schaltungsanordnung mit einem Steuergerät, das mindestens einen binären Eingang zur Erfassung des Schaltzustandes eines zugeordneten Schalters aufweist, der Eingang mit einem Pulldown-Widerstand beschaltet ist, wobei der Pulldown-Widerstand ein Kaltleiter ist.

In Bezug auf das Betriebsverfahren wird die Aufgabe durch ein Verfahren zum Betreiben einer Schaltungsanordnung mit einem Steuergerät gelöst, bei welchem das Steuergerät mindestens einen binären Eingang zur Erfassung des Schaltzustandes eines zugeordneten Schalters aufweist, wobei der Eingang mit einem Pulldown-Widerstand beschaltet ist, bei dem anhand der gemessenen Spannung am Pulldown-Widerstand die Ausbildung von Kriechwegen am Schalter detektiert wird.

Vorteilhafte Ausgestaltungen und Weiterentwicklungen der grundlegenden Idee sind Gegenstand der Unteransprüche sowie der nachfolgenden detaillierten Beschreibung.

Durch eine Beschaltung eines binären Eingangs mit einem Pull-down-Widerstand ändert sich der Spannungsteiler aus Kriechweg und binärem Eingang, so dass der Isolationswiderstand weiter einbrechen muss, bevor beispielsweise die halbe Steuerspannung am binären Eingang anliegt und die Schaltschwelle erreicht ist. Gleichzeitig erhöht sich der Stromfluss über den Kriechweg. Im besten Fall wird die Ursache für die Ausbildung des Kriechwegs durch den Stromfluss beseitigt, indem beispielsweise Rußpartikel verbrannt werden.

Durch die Beschaltung mit einem Pulldown-Widerstand wird das oben erläuterte Problem in der Regel dahingehend entschärft, dass eine größere Verschmutzung und damit ein größerer Einbruch der Isolationsstrecke notwendig ist, um eine ungewollte Freigabe bzw. einen Steuerbefehl auszulösen. Weist der Kriechweg jedoch eine hohe Stromtragfähigkeit auf, muss der Pulldown-Widerstand so dimensioniert werden, dass er eine entsprechende Leistung umsetzen kann. Problematisch hierbei ist die große Bauform, hohe Kosten sowie eine benötigte Wärmeabfuhr für einen entsprechend dimensionierten Widerstand. Weiterhin ist es nachteilig, dass keinerlei Information über den aktuellen Status der eingebrochenen Isolation verfügbar ist.

Erfindungsgemäß wird daher der jeweilige binäre Eingang des Steuerungsgeräts wird mit einem Kaltleiter beschaltet. Kaltleiter, die auch als PTC-Widerstände (englisch: Positive Temperature Coefficient) bezeichnet werden, sind stromleitende Materialien, die bei tieferen Temperaturen den Strom besser leiten können als bei hohen. Ihr elektrischer Widerstand vergrößert sich bei steigender Temperatur. Im Normalfall, bei geöffnetem Schaltkontakt mit hohem Isolationswiderstand, hat der Kaltleiter daher einen geringen Widerstandswert und reduziert so den Eingangswiderstand des binären Eingangs. Im Falle einer sich ausbreitenden Kriechstrecke jedoch wird der Stromfluss in den binären Eingang deutlich erhöht. Weist die Kriechstrecke eine relativ hohe Stromtragfähigkeit auf, kommt es zu einer Erwärmung des Kaltleiters. Dadurch wird dessen Widerstandswert erhöht und die in ihm umgesetzte elektrische Leistung reduziert. Damit wird insbesondere eine geringe Wärmeentwicklung in allen möglichen Betriebszuständen erreicht. Aufwendige Maßnahmen zur Wärmeabfuhr erübrigen sich.

Gemäß einer vorteilhaften Ausgestaltung der Erfindung ändert sich der Widerstandswert des auch als Thermistor bezeichneten PTC-Widerstands deutlich, wenn die Temperatur von Zimmertemperatur (rund 20 °C) auf etwa 100 °C bis 150 °C steigt. Vorteilhafterweise verdoppelt er sich in diesem Fall mindestens, besonders bevorzugt vervierfacht er sich mindestens, und idealerweise wächst er sogar um eine Größenordnung oder mehr. Zum Beispiel liegt der Widerstand bei 20 °C etwa in der Größenordnung 1 kOhm (10^3 Ohm) und bei 125 °C in der Größenordnung 10 bis 100 kOhm (10^4 Ohm bis 10^5 Ohm) oder mehr.

Gemäß einer weiteren vorteilhaften Ausgestaltung der Erfindung liegt der binäre Eingang der Schaltungsanordnung nach Art eines Spannungsteilers zwischen dem Schalter und dem Pulldown-Widerstand an.

Um zugleich eine besonders zuverlässige Erfassung der möglichen Schaltzustände zu erreichen, weist die Schaltungsanordnung in bevorzugter Ausgestaltung ferner Mittel zur Messung der am Pulldown-Widerstand abfallenden Spannung auf, wodurch in nachfolgend beschriebener Weise eine Überwachung des Zustandes der Kriechwege ermöglicht wird. Damit kann die Schaltungsanordnung eine Rückmeldung zum Status der sich ausbildenden Kriechwege bzw. zum Status der eingebrochenen Isolation liefern.

Zu diesem Zweck weist die Schaltungsanordnung bevorzugt eine Überwachungseinheit auf, die Mittel zur Auswertung der gemessenen Spannung am Pulldown-Widerstand besitzt.

Das Spannungsmessgerät kann in die Überwachungseinheit integriert sein. Gegebenenfalls kann auch der Pulldown-Widerstand selber baulich in die Überwachungseinheit integriert und über zugehörige Leitungen in der beschriebenen Weise an das Steuergerät angeschlossen sein.

Besonders vorteilhaft ist die Überwachungseinheit derart ausgebildet und konfiguriert, dass sie eine Warnmeldung ausgibt, sobald die gemessene Spannung über eine vorgegebene Mindestzeitspanne hinweg eine vorgegebene Warnschwelle überschreitet.

Darüber hinaus löst die Überwachungseinheit vorteilhafterweise einen Alarm aus, sobald die gemessene Spannung über eine vorgegebene Mindestzeitspanne hinweg eine vorgegebene Alarmschwelle überschreitet. Die Alarmschwelle liegt dabei zweckmäßigerweise höher als die Warnschwelle.

In diesem Zusammenhang wird es als vorteilhaft angesehen, wenn das Steuergerät eine elektronische Verriegelung besitzt, die derart an die Überwachungseinheit gekoppelt ist, dass eine Alarmauslösung die Verriegelung aktiviert. Die Verriegelung bewirkt, dass das Steuergerät keine Schalthandlungen mehr durchführt bzw. keine Steuerbefehle mehr ausgibt, bis eine vorzugsweise manuelle Entriegelung durch einen Reset-Taster oder ähnliches erfolgt.

Hinsichtlich des Verfahrens zum Betreiben der Schaltungsanordnung wird die eingangs genannte Aufgabe gelöst, indem anhand der gemessenen Spannung am Pulldown-Widerstand die Ausbildung von Kriechwegen am Schalter detektiert wird.

Vorteilhaftweise wird dabei aus der gemessenen Spannung ein den Isolationswiderstand des Schalters im Öffnungszustand kennzeichnender Wert ermittelt und zweckmäßigerweise bei Unterschreiten eines als kritisch angesehenen Wertes eine Warnung oder ein Alarm ausgelöst.

Die mit der Erfindung erzielten Vorteile bestehen insbesondere darin, dass die bewährte Grundstruktur und Grundfunktion bekannter Schaltungsanordnungen beibehalten werden kann und dennoch die eingangs geschilderten Probleme vermieden werden. Durch die Beschaltung des jeweiligen binären Eingangs des Steuerungsgeräts mit einem Kaltleiter wird der Eingangswiderstand des Eingangs reduziert, so dass der binäre Eingang unempfindlicher wird. Der Isolationswiderstand der Klemmstelle muss auf einen viel geringeren Wert einbrechen, bevor der Eingang aktiviert wird, als es ohne die Beschaltung der Fall ist. Weiterhin muss ein größerer Strom über den Kriechweg fließen, bevor eine Freigabe aufgehoben oder eine Schalthandlung ausgeführt wird. Hierdurch kommt es in vielen Fällen zu einer selbstreinigenden Wirkung, da die Ursache für den Kriechweg durch den Strom aufgelöst wird. Durch die Erhöhung des Widerstandswertes im Falle eines permanenten Stromflusses beim Fortschreiten der Kriechwegbildung wird die am Pulldown-Widerstand umgesetzte Wärmeleistung verringert. Hierdurch kann auf die bislang erforderliche großvolumige Dimensionierung und Kühlung des Widerstandes verzichtet werden.

Durch die Messung und Auswertung der am Pulldown-Widerstand abfallenden elektrischen Spannung ist es ferner möglich, Rückschlüsse über das Voranschreiten der Kriechwegbildung zu ziehen oder, anders formuliert, eine Herabsetzung des Isolationswiderstandes unter einen kritischen Wert am Schalter zu detektieren. Durch die Ausgabe einer Warnung ist es möglich, vor Ort sowie über die Ferne einen sich anbahnenden Kriechweg frühzeitig zu erkennen und entsprechende Maßnahmen zu ergreifen. Durch die Ausgabe eines Alarms und die damit verbundene Aufhebung der Freigabe des Steuerungsgerätes werden falsche Freigaben sowie ungewollte Schalthandlungen unterbunden. Ebenso ist vor Ort sowie über die Ferne erkennbar, dass die Anlage ein Isolationsproblem aufweist und im derzeitigen Zustand kein sicherer Betrieb mehr gewährleistet ist.

Ausführungsbeispiele der Erfindung werden nachfolgend anhand von Zeichnungen näher erläutert. Dabei zeigt in jeweils stark vereinfachter und schematisierter Darstellung:
- FIG 1: eine Schaltungsanordnung mit einem einen binären Eingang aufweisenden Steuergerät,
- FIG 2: eine Variante der Schaltungsanordnung gemäß FIG 1 im Ausschnitt,
- FIG 3: eine Überwachungseinheit für elektrische Isolationseigenschaften der Schaltungsanordnung gemäß FIG 1,
- FIG 4: ein erstes Beispiel für den zeitlichen Verlauf einer zur Beurteilung von elektrischen Isolationseigenschaften der Schaltungsanordnung gemäß FIG 1 gemessenen Spannung, und
- FIG 5: ein zweites Beispiel für den zeitlichen Verlauf der gemessenen Spannung.

Gleiche oder gleichwirkende Teile sind in allen Figuren mit denselben Bezugszeichen versehen.

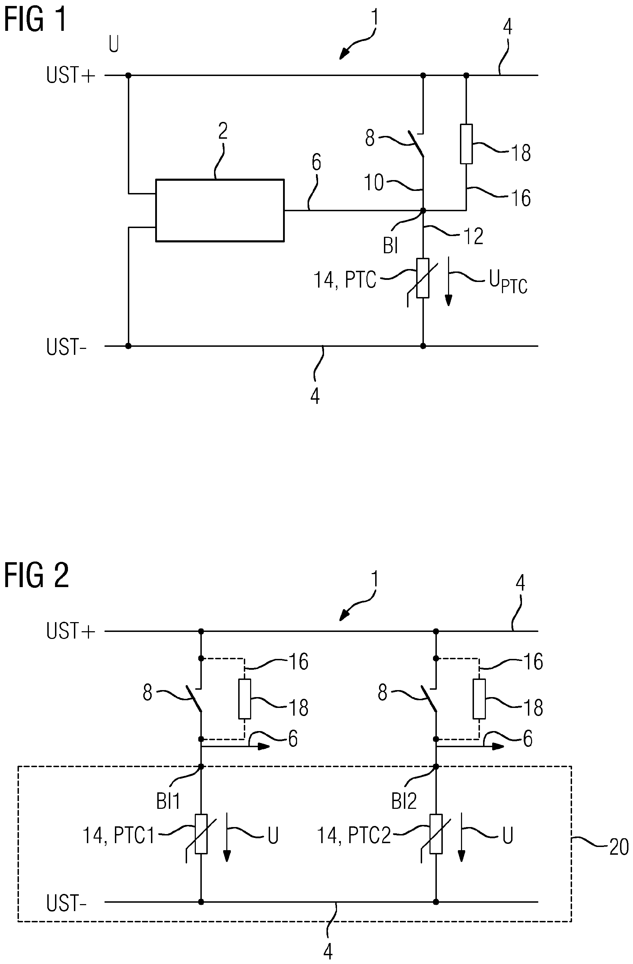

FIG 1 zeigt in schematischer Darstellung eine Schaltungsanordnung 1. Die Schaltungsanordnung 1 umfasst ein Steuergerät 2, insbesondere einer Motorsteuerung, welches über elektrische Anschlüsse und über als Verteiler 4 ausgebildete elektrische Leiter mit dem Pluspol UST+ einerseits und dem Minuspol UST- andererseits einer zugeordneten Spannungsquelle verbunden ist. Der Minuspol UST- kann zugleich Masse der elektrischen Schaltung sein. Das Steuergerät 2 wird somit mit einer Betriebsspannung U, die der Potentialdifferenz zwischen Pluspol UST+ und Minuspol UST- entspricht, versorgt. Die Betriebsspannung U des Steuergerätes 2 wird auch Steuerspannung genannt.

Das Steuergerät 2 dient hier im Ausführungsbeispiel zur Ansteuerung eines zugeordneten Motors und weist mindestens einen direkt oder indirekt mit dem Motor verbundenen Ausgang auf (hier nicht dargestellt). Man spricht im Englischen auch von einer Motor Control Unit (MCU). Anstelle eines Motors kann das Steuergerät 2 auch zur Ansteuerung von anderen elektrischen Geräten vorgesehen sein.

Des Weiteren weist das Steuergerät 2 mindestens einen Eingang 6 auf, mit dem der Schaltzustand eines zugeordneten Schaltelements oder kurz Schalters 8 abgefragt wird. Bei dem Schalter 8 kann es sich um einen mechanisch oder anderweitig betätigten Schalter handeln, insbesondere auch einen Taster oder alternativ ein komplexes elektronisches Schaltgerät. Je nach Schaltzustand öffnet oder schließt der Schalter 8 einen zugehörigen Schaltstromkreis, was über das Steuergerät 2 erfasst und gemäß der darin implementierten Steuerlogik in Steuerbefehle umgesetzt wird. Im Falle einer Motorsteuerung beispielsweise werden derartige Steuerbefehle über den Ausgang des Steuergerätes 2 an den zugeordneten Motor übermittelt.

Der Schaltstromkreis wird im vorliegenden Fall nach Art einer Parallelschaltung über die Verteiler 4 von derselben Spannungsquelle gespeist wie das Steuergerät 2. Die Schaltstrecke umfasst einen ersten, eingangsseitig mit dem Pluspol UST+ verbundenen Leitungsanschnitt 10, in den der Schalter 8 geschaltet ist, sowie einen zweiten, ausgangsseitig mit dem Minuspol UST- verbundenen Leitungsabschnitt 12, in den ein als Pulldown-Widerstand 14 bezeichneter elektrischer Widerstand geschaltet ist. Der Eingang 6 des Steuergerätes 2 liegt nach Art eines Spannungsteilers zwischen dem ersten Leitungsabschnitt 10 und dem zweiten Leitungsabschnitt 12 an dem Schaltstromkreis an, also zwischen Schalter 8 und Pulldown-Widerstand 14 (Kontakt BI). Mit anderen Worten geht der erste Leitungsabschnitt 10 an der mit dem Eingang 6 des Steuergerätes 2 verbundenen Abzweigung in den zweiten Leitungsabschnitt 12 über.

Entsprechend den zu erfassenden beiden möglichen Schaltstellungen des Schalters 8 ist der Eingang 6 des Steuergerätes 2 ein digitaler, nämlich binärer Eingang. Der Eingang 6 ist vom Typ "HIGH aktiv" und schaltet bei anliegendem Potential ab einer bestimmten Schaltschwelle, typischerweise 0,5 × Steuerspannung U, von logisch 0 (LOW) auf logisch 1 (HIGH). Der Schalter 8 befindet sich während des Betriebs der Schaltungsanordnung 1 normalerweise im geöffneten Zustand, so dass das zu erfassende Schaltereignis typischerweise das Schließen ist.

Insbesondere bei ungünstigen Umgebungseinflüssen (Feuchtigkeit, Verschmutzung etc.) können sich in/an dem Schalter 8 Kriechwege ausbilden, so dass der Schaltstromkreis bei geöffneten Schaltkontakten des Schalters 8 einen Kriechstrom führt. Dies ist in FIG 1 nach Art eines Ersatzschaltbildes durch den die Schaltkontakte des Schalters 8 überbrückenden Kriechweg 16 veranschaulicht, der einen auch als Isolationswiderstand 18 bezeichneten Kriechwiderstand besitzt. Dementsprechend kann es zu Potentialverschiebungen an dem von dem binären Eingang 6, dem Kriechweg 16 im ersten Leitungsabschnitt 10 und dem Pulldown-Widerstand 14 im zweiten Leitungsabschnitt 12 gebildeten Spannungsteiler kommen. Dadurch können Falscherfassungen des Schaltzustandes des Schalters 8 erfolgen, welche wiederum zu nicht beabsichtigten Freigaben, Rückmeldungen und Steuerbefehlen des Steuergerätes 2, also fehlerhaften Schaltvorgängen führen können.

Um dem entgegenzuwirken, ist der im zweiten Leitungsabschnitt 12 des Schaltstromkreises geschaltete Pulldown-Widerstand 14 hinsichtlich seines Widerstandswertes geeignet, nämlich vergleichsweise niederohmig dimensioniert. Bei einer konkreten Realisierung der Schaltung ist es beispielsweise auch möglich, einen dezidierten Pulldown-Widerstand 14 parallel zu einem bereits vorhandenen oder immanenten hochohmigen Widerstand zu schalten. Durch diese Maßnahme wird der Eingangswiderstand des binären Eingangs 6 herabgesetzt. Dadurch wird der Eingang 6 unempfindlicher gegenüber einer betriebs- oder umweltbedingten allmählichen Herabsetzung des Isolationswiderstandes 18 im Kriechweg 16. Die Schaltschwelle wird somit erst später erreicht, nämlich wenn der Isolationswiderstand 18 noch weiter eingebrochen ist.

Allerdings erhöht sich durch diese Maßnahme der Stromfluss durch den Kriechweg 16. Dies führt zwar in einigen Fällen zu einer Selbstreinigung, indem die Ursache für den Kriechweg 16 durch den Stromfluss selber aufgelöst wird, etwa wenn Rußpartikel verbrannt werden. Man kann sich jedoch nicht darauf verlassen, dass dies immer passiert. Weist der Kriechweg 16 eine hohe Stromtragfähigkeit auf, so muss der Pulldown-Widerstand 14 derart dimensioniert werden, dass er eine entsprechende elektrische Leistung umsetzen kann. Dabei ist insbesondere die Abfuhr der Verlustwärme durch geeignete Maßnahmen sicherzustellen.

Zur Vermeidung derartiger Nachteile ist bei der Schaltungsanordnung 1 gemäß FIG 1 der Pulldown-Widerstand 14 als Kaltleiter ausgebildet. Kaltleiter, die auch als PTC-Widerstände (englisch: Positive Temperature Coefficient) bezeichnet werden, sind stromleitende Materialien, die bei tieferen Temperaturen den Strom besser leiten können als bei hohen. Ihr elektrischer Widerstand vergrößert sich bei steigender Temperatur. Ein PTC-Widerstand besitzt somit einen positiven Temperaturkoeffizienten.

Im Normalfall, bei hohem Isolationswiderstand 18 und dementsprechend geringem Kriechstrom, hat der Pulldown-Widerstand 14 einen relativ geringen Widerstandswert und reduziert so den Eingangswiderstand des binären Eingangs 6. Die Wirkungsweise ist dann so wie bereits oben beschrieben. Im Falle einer sich ausbreitenden Kriechstrecke erhöht sich der Stromfluss in den binären Eingang 6 deutlich. Weist der Kriechweg 16 eine hohe Stromtragfähigkeit auf, kommt es zu einer Erwärmung des den Pulldown-Widerstand 14 bildenden Kaltleiters. Dadurch wird dessen Widerstandswert erhöht und die in ihm umgesetzte Leistung reduziert sich gemäß der Relation P = U²/R. Damit erübrigen sich aufwendige Kühlmaßnahmen. Der Pulldown-Widerstand 14 kann überdies baulich wesentlich kleiner ausfallen als bei der Verwendung gewöhnlicher, temperaturunabhängiger Widerstände.

Ein paar exemplarische Zahlenwerte mögen dies verdeutlichen:
Bei einem typischen Widerstandswert eines Pulldown-Widerstands von 5 kOhm würde bei einer anliegenden Spannung von 220 V DC und einer stromtragfähigen Kriechstrecke eine permanente Leistungsumsetzung von rund 9,7 W zwingend eine Kühlung erforderlich machen. Bei einem PTC-Widerstand hingegen, der bei einer Betriebstemperatur von 20 °C einen Widerstandswert von 5 kOhm besitzt, welcher bei einer kriechstrombedingten Erwärmung auf z. B. 125 °C auf einen Wert von 20 kOhm ansteigt, ist bei einer Leistungsumsetzung von rund 2,4 W keine dezidierte Kühlung erforderlich.

FIG 2 zeigt einen Ausschnitt aus einer ähnlichen Schaltungsanordnung 1 wie in FIG 1, wobei zusätzlich ein baugleicher zweiter Spannungsteiler in Parallelschaltung zu dem ersten Spannungsteiler an die beiden Pole UST+ und UST- der Spannungsquelle angeschlossen ist. Der zweite Spannungsteiler ist analog dem ersten Spannungsteiler an einen zugehörigen (zweiten) binären Eingang 6 des Steuergerätes 2 angeschlossen (gekennzeichnet durch den nach rechts weisenden Pfeil). In entsprechender Verallgemeinerung kann das Steuergerät 2 eine Vielzahl von binären Eingängen 6 aufweisen, die vorzugsweise alle in gleichartiger Weise beschaltet sind, und die eine Vielzahl von individuell zugeordneten Schaltern 8 bezüglich ihrer Schaltstellung überwachen. Ein der jeweiligen Bezeichnung nachgestellter nummerischer Index 1, 2, 3, ... kann dann zur Unterscheidung der verschiedenen Schaltungszweige verwendet werden.

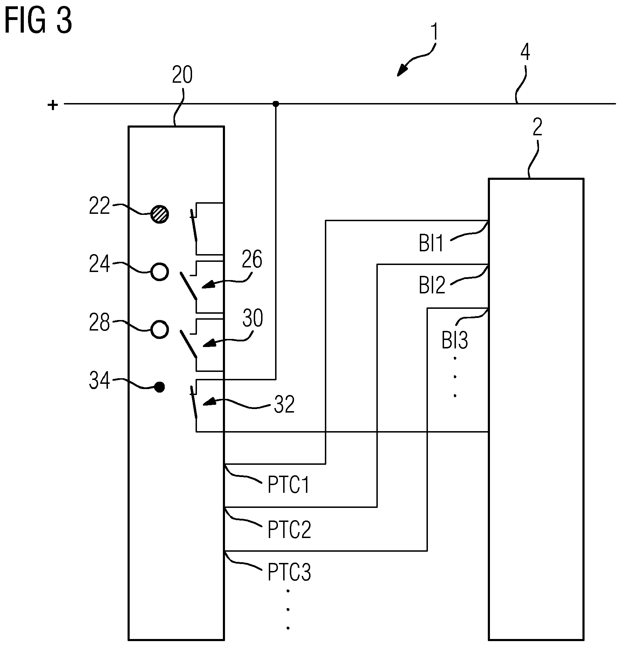

Über die oben beschriebene, gewissermaßen intrinsische Verbesserung der Betriebscharakteristik bei der Ausbildung von Kriechwegen 16 hinaus ist bei der Schaltungsanordnung 1 gemäß FIG 1 oder FIG 2 eine quantitative Überwachung des Zustandes der Kriechwege 16 durch eine bedarfsweise ankoppelbare Überwachungseinheit 20 vorgesehen. Diese auch als Isolationswächter bezeichnete Überwachungseinheit 20 ist in FIG 3 rein schematisch neben dem ihr zugeordneten Steuergerät 2 dargestellt (die Details betreffend die Spannungsteilerschaltungen sind in dieser Darstellung weggelassen worden).

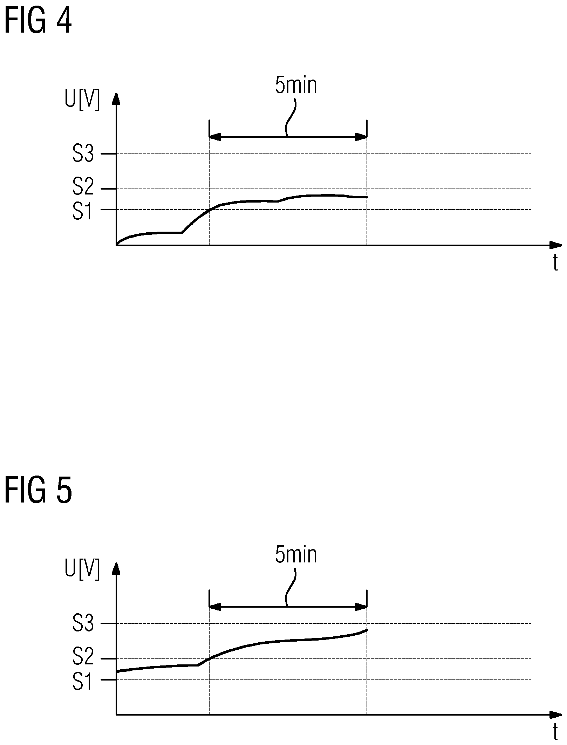

Die Überwachung beruht im Kern darauf, dass über entsprechende Kontakte permanent der Spannungsabfall UPTC über dem Pull-down-Widerstand 14 abgegriffen und gemessen wird, wie in FIG 1 schematisch angedeutet ist. Zwei mögliche Verläufe der gemessenen Spannung UPTC als Funktion der Zeit t sind in FIG 4 und FIG 5 diagrammatisch dargestellt.

Die jeweils am Kontakt BI (beispielsweise gegenüber dem Minuspol als Bezugspotenzial) abgegriffene und gemessene Spannung UPTC wird der Überwachungseinheit 20 gemäß FIG 3 über den mit PTC gekennzeichneten Anschluss zugeführt und wie folgt ausgewertet:
Die Betriebsbereitschaft der Überwachungseinheit 20 wird beispielsweise visuell durch eine Betriebsleuchte 22 (etwa in der Signalfarbe Grün) angezeigt.

Bei Überschreitung einer ersten Schwelle S1 (beispielsweise 0,15 × Steuerspannung U) über einen bestimmten Zeitraum (z. B. 5 Minuten) hinweg wird eine Warnung für den Betreiber der Steuerungseinrichtung ausgegeben. Die Warnung kann beispielsweise visuell mittels einer Warnleuchte 24 (etwa in der Signalfarbe Gelb) erfolgen sowie über einen Fernmeldekontakt 26 an weitere Überwachungs- und Diagnosesysteme weitergeleitet werden. Diese Warnung bedeutet, dass sich ein Kriechweg 16 anbahnt und der Betreiber zeitnah seine Anlage untersuchen und gegebenenfalls die von der Ausbildung eines Kriechwegs 16 betroffene Stellen reinigen muss.

Bei Überschreitung einer zweiten Schwelle S2 (beispielsweise 0,25 × Steuerspannung U) über einen bestimmten Zeitraum hinweg wird ein Alarm für den Betreiber der Steuerungseinrichtung ausgegeben. Der Alarm kann beispielsweise visuell mittels einer Alarmleuchte 28 (etwa in der Signalfarbe Rot) erfolgen sowie über einen Fernmeldekontakt 30 an weitere Überwachungs- und Diagnosesysteme weitergeleitet werden. Der Alarm bedeutet, dass ein kritischer Kriechweg 16 besteht und kein sicherer Betrieb mehr gewährleistet ist, da unter Umständen ungewollte Schaltvorgänge ausgelöst werden.

Optional wird bei Überschreitung der Schwelle S2 oder alterativ einer dritten Schwelle S3 ein Verrieglungskontakt 32 geöffnet, welcher in den Freigabepfad des Steuergerätes 2 eingebunden ist. Bei offenem Verriegelungskontakt 32 fehlt dem Steuergerät 2 die Freigabe und Schaltvorgänge sind ab diesem Zeitpunkt nicht mehr möglich. Das Steuergerät 2 ist damit verriegelt. Der Betreiber muss umgehend den Kriechweg 16 beseitigen, bevor er seine Anlage wieder schalten kann.

Weiterhin bleibt die Warnung bzw. der Alarm vorteilhafterweise bestehen, auch wenn die gemessene Spannung UPTC am Pull-down-Widerstand 14 wieder unterhalb von Schwelle S1 bzw. Schwelle S2 fällt. Erst über einen Reset-Taster 34 lässt sich der Normalbetrieb wieder herstellen.

Zur Durchführung der beschriebenen Operationen ist die Überwachungseinheit 20 mit geeigneter Hardware und/oder Software bestückt. Dies umfasst beispielsweise Mittel zur Spannungsmessung, Analog-Digital-Konverter, Signalverlaufsspeicher, Spitzenwertspeicher, Schwellenwertspeicher, Komparatoren etc.

Die Überwachungseinheit 20 kann prinzipiell auch bei Schaltungsanordnungen der beschriebenen Art mit gewöhnlichen, nicht-temperaturabhängigen Pulldown-Widerständen 14 verwendet werden. Besonders vorteilhaft kommt sie jedoch dann zum Einsatz, wenn der Pulldown-Widerstand 14 ein Kaltleiter ist wie oben beschrieben.

## Patentansprüche

1. Schaltungsanordnung (1) mit einem Steuergerät (2), das mindestens einen binären Eingang (6) zur Erfassung des Schaltzustandes eines zugeordneten Schalters (8) aufweist, wobei der binäre Eingang (6) mit einem Pulldown-Widerstand (14) beschaltet ist, **dadurch gekennzeichnet, dass** der Pulldown-Widerstand (14) ein Kaltleiter ist.

2. Schaltungsanordnung (1) nach Anspruch 1, wobei der Widerstandswert des Pulldown-Widerstands (14) bei einer Temperaturerhöhung von 20 °C auf 125 °C sich mindestens verdoppelt und vorzugsweise um eine Größenordnung ansteigt.

3. Schaltungsanordnung (1) nach Anspruch 1 oder 2, wobei der Eingang (6) nach Art eines Spannungsteilers zwischen dem Schalter (8) und dem Pulldown-Widerstand (14) anliegt.

4. Schaltungsanordnung (1) nach einem der Ansprüche 1 bis 3 mit Mitteln zur Messung der am Pulldown-Widerstand (14) abfallenden Spannung (UPTC).

5. Schaltungsanordnung (1) nach Anspruch 4 mit einer Überwachungseinheit (20), die Mittel zur Auswertung der gemessenen Spannung (UPTC) aufweist.

6. Schaltungsanordnung (1) nach Anspruch 5, wobei die Überwachungseinheit (20) eine Warnmeldung ausgibt, sobald die gemessene Spannung (UPTC) über eine vorgegebene Mindestzeitspanne hinweg eine vorgegebene Warnschwelle (S1) überschreitet.

7. Schaltungsanordnung (1) nach Anspruch 5 oder 6, wobei die Überwachungseinheit (20) einen Alarm auslöst, sobald die gemessene Spannung (UPTC) über eine vorgegebene Mindestzeitspanne hinweg eine vorgegebene Alarmschwelle (S2) überschreitet.

8. Schaltungsanordnung (1) nach Anspruch 7, wobei das Steuergerät (2) eine elektronische Verriegelung besitzt, die derart an die Überwachungseinheit (20) gekoppelt ist, dass eine Alarmauslösung die Verriegelung aktiviert.

9. Verfahren zum Betreiben einer Schaltungsanordnung (1) mit einem Steuergerät (2), das mindestens einen binären Eingang (6) zur Erfassung des Schaltzustandes eines zugeordneten Schalters (8) aufweist, wobei der binäre Eingang (6) mit einem Pulldown-Widerstand (14) beschaltet ist, **dadurch gekennzeichnet, dass** anhand der gemessenen Spannung (UPTC) am Pulldown-Widerstand (14) die Ausbildung von Kriechwegen (16) am Schalter (8) detektiert wird.

10. Verfahren nach Anspruch 9, wobei aus der gemessenen Spannung (UPTC) ein den Isolationswiderstand (18) des Schalters (8) im Öffnungszustand kennzeichnender Wert ermittelt wird.

## Claims

1. Circuit arrangement (1) comprising a control device (2) having at least one binary input (6) for the detection of the switching state of an associated switch (8), wherein the binary input (6) is interconnected with a pull-down resistor (14), **characterized in that** the pull-down resistor (14) is a PTC thermistor.

2. Circuit arrangement (1) according to Claim 1, wherein the resistance value of the pull-down resistor (14) is at least doubled, and is preferably increased by one order of magnitude, in response to a temperature increase from 20°C to 125°C.

3. Circuit arrangement (1) according to Claim 1 or 2, wherein the input (6) is arranged between the switch (8) and the pull-down resistor (14), in the manner of a voltage divider.

4. Circuit arrangement (1) according to one of Claims 1 to 3, having means for the measurement of the voltage (UPTC) on the pull-down resistor (14).

5. Circuit arrangement (1) according to Claim 4, having a monitoring unit (20) which incorporates means for the evaluation of the measured voltage (UPTC).

6. Circuit arrangement (1) according to Claim 5, wherein the monitoring unit (20) generates a warning signal, immediately the measured voltage (UPTC) over a predefined minimum time interval exceeds a predefined warning threshold (S1).

7. Circuit arrangement (1) according to Claim 5 or 6, wherein the monitoring unit (20) trips an alarm, immediately the measured voltage (UPTC) over a predefined minimum time interval exceeds a predefined alarm threshold (S2).

8. Circuit arrangement (1) according to Claim 7, wherein the control device (2) incorporates an electronic lock-out function, which is coupled to the monitoring unit (20) such that the lock-out function is activated if an alarm is tripped.

9. Method for the operation of a circuit arrangement (1) comprising a control device (2) having at least one binary input (6) for the detection of the switching state of an associated switch (8), wherein the binary input (6) is interconnected with a pull-down resistor (14), **characterized in that** the formation of creepage paths (16) on the switch (8) is detected by means of the measured voltage (UPTC) on the pull-down resistor (14).

10. Method according to Claim 9, wherein a value which is characteristic of the insulation resistance (18) of the switch (8) in the open state is determined from the measured voltage (UPTC).

## Revendications

1. Montage (1) comprenant un appareil (2) de commande, qui a au moins une entrée (6) binaire de détection de l'état de commutation d'un interrupteur (8) associé, dans lequel l'entrée (6) binaire est reliée à une résistance (14) pulldown, **caractérisé en ce que** la résistance (14) pulldown est un conducteur à froid.

2. Montage (1) suivant la revendication 1, dans lequel la valeur de la résistance (14) pulldown double au moins pour une élévation de la température de 20°C à 125°C et augmente, de préférence, d'un ordre de grandeur.

3. Montage (1) suivant la revendication 1 ou 2, dans lequel l'entrée (6) s'applique entre l'interrupteur (8) et la résistance (14) pulldown à la manière d'un diviseur de tension.

4. Montage (1) suivant l'une des revendications 1 à 3, comprenant des moyens de mesure de la tension (UPTC) chutant aux bornes de la résistance (14) pulldown.

5. Montage (1) suivant la revendication 4, comprenant une unité (20) de contrôle, qui a des moyens d'analyse de la tension (UPTC) mesurée.

6. Montage (1) suivant la revendication 5, dans lequel l'unité (20) de contrôle émet un message d'avertissement, dès que la tension (UPTC) mesurée dépasse un seuil (S1) d'avertissement donné à l'avance pendant un laps de temps minimum donné à l'avance.

7. Montage (1) suivant la revendication 5 ou 6, dans lequel l'unité (20) de contrôle déclenche une alerte, dès que la tension (UPTC) mesurée dépasse un seuil (S2) d'alerte donné à l'avance pendant un laps de temps minimum donné à l'avance.

8. Montage (1) suivant la revendication 7, dans lequel l'appareil (2) de commande possède un verrouillage électronique, qui est connecté à l'unité (20) de contrôle, de manière à ce qu'un déclenchement d'une alerte active le verrouillage.

9. Procédé pour faire fonctionner un montage (1) comprenant un appareil (2) de commande, qui a au moins une entrée (6) binaire de détection de l'état de commutation d'un interrupteur (8) associé, dans lequel l'entrée (6) binaire est reliée à une résistance (14) pulldown, **caractérisé en ce que**, à l'aide de la tension (UPTC) mesurée aux bornes de la résistance (14) pulldown, on détecte la formation de lignes (16) de fuite à l'interrupteur (8) .

10. Procédé suivant la revendication 9, dans lequel, à partir de la tension (UPTC) mesurée, on détermine une valeur caractérisant la résistance (18) d'isolation de l'interrupteur (8) à l'état ouvert.
